(19) **Europäisches Patentamt European Patent Office Office européen des brevets**

(11) **EP 3 209 071 B1**

(12) **EUROPEAN PATENT SPECIFICATION**

(45) Date of publication and mention
of the grant of the patent:
**19.12.2018 Bulletin 2018/51**

(21) Application number: **15862102.9**

(22) Date of filing: **24.06.2015**

(51) Int Cl.:
*H04W 52/52* (2009.01)     *H03F 1/02* (2006.01)
*H04B 17/12* (2015.01)     *H04B 17/391* (2015.01)
*H03F 1/32* (2006.01)     *H03F 3/24* (2006.01)

(86) International application number:
**PCT/CN2015/082242**

(87) International publication number:
**WO 2016/078411 (26.05.2016 Gazette 2016/21)**

(54) **VOLTAGE REGULATION METHOD AND APPARATUS FOR POWER AMPLIFIER**

SPANNUNGSREGELUNGSVERFAHREN UND VORRICHTUNG FÜR LEISTUNGSVERSTÄRKER

PROCÉDÉ ET APPAREIL DE RÉGULATION DE TENSION POUR UN AMPLIFICATEUR DE
PUISSANCE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **20.11.2014 CN 201410667925**

(43) Date of publication of application:
**23.08.2017 Bulletin 2017/34**

(73) Proprietor: **ZTE Corporation
Shenzhen, Guangdong 518057 (CN)**

(72) Inventors:
• **CHEN, Yonghong
Shenzhen
Guangdong 518057 (CN)**

• **GUO, Tiansheng
Shenzhen
Guangdong 518057 (CN)**
• **ZHANG, Jinchao
Shenzhen
Guangdong 518057 (CN)**

(74) Representative: **Savi, Massimiliano et al
NOTARBARTOLO & GERVASI S.p.A.
Corso di Porta Vittoria 9
20122 Milano (IT)**

(56) References cited:
**EP-A1- 2 226 932**     **CN-A- 101 316 128**
**CN-A- 102 033 555**     **CN-A- 102 740 437**
**CN-A- 103 098 525**     **US-A1- 2001 054 931**

## Description

## Technical Field

The present invention relates to the field of the communication technology, and more particularly, to a method and apparatus for regulating a voltage of a power amplifier.

## Background

With the rapid increase in data traffic and the rapid expansion of network size, the stress of energy saving and emission reduction for telecommunication operators is increasing gradually. According to statistics, annual power consumption of every single one of traditional base stations is as high as 15,000 kwh. Thus, how to reduce operational energy consumption of the base stations has become an issue which has attracted more and more attention from the operators. Energy consumption of mobile base stations which are the most important parts of a mobile communication network, accounts for 90%, therefore, energy-saving design of the mobile base stations has become the most important and key factor in energy saving and emission reduction of the mobile network, and is an important direction in technology evolution of the current mobile base station products and improvement of market competitiveness.

Power amplifiers are high-power transmitting modules in the mobile base stations, and their power consumption in the base stations with 80W rated power accounts for about 80% of the total power consumption of the base stations. Therefore, the energy-saving design for the power amplifiers is extremely important. Transmitting power of the mobile base stations is low when bearer service and traffic are low, at this point, a supply voltage of a power amplifier can be regulated to a lower position, and when the bearer service and traffic increase, the supply voltage needs to be increased as transmitting power of the power amplifier increases.

In the related art, a mobile base station power amplifier voltage regulation technology generally uses the average power as a criterion for determining a voltage tap position, which applies to a single application scenario where a peak-to-average power ratio of a signal is configured to be constant. If configuration of the transmitting signal changes, in the case that the peak-to-average power ratio of the output signal greatly changes, a corresponding relationship between the average power and the supply voltage of the power amplifier will change. If the supply voltage does not meet requirements of the output power of the power amplifier, an output radio frequency index will seriously deteriorate, thus resulting in a transmitter being unable to work normally.

In addition, there are some power amplifier voltage regulation designs for single-standard wireless products. For example, the supply voltage of the power amplifier is indexed according to a transmitting power level or the number of activated carriers in Global System for Mobile Communication (GSM) products, while power amplifier voltage regulation is designed based on symbol power and traffic statistics in long-term evolution (LTE) products. These methods, which can be used for single-standard wireless base station products, cannot be applied to multi-standard common platform base station products.

Therefore, the power amplifier voltage regulation technology in the related art is only applicable to single-standard base stations and cannot be applied to multi-standard base stations, and there will be the case that transmitters cannot work normally after the voltage of the power amplifier is regulated.

EP 2226932 A1 discloses a method for amplifying a carrier signal by using a power amplifier.

Summary

The present disclosure provides a method for regulating a voltage of a power amplifier according to claim 1 and an apparatus for regulating a voltage of a power amplifier according to claim 9.

Also provided is a method for regulating a voltage of a power amplifier, the method being applied to multi-standard base stations and including following steps:

   acquiring an average power and a peak-to-average power ratio of a transmitting signal;

   acquiring a peak power of the transmitting signal according to the average power and the peak-to-average power ratio; and

   regulating an operating voltage of the power amplifier according to the peak power and a saturation power of the power amplifier.

In an exemplary embodiment, the step of regulating an operating voltage of a power amplifier according to the peak power and a saturation power of the power amplifier includes:

when the peak power is greater than a maximum power in a power range corresponding to a current operating voltage of the power amplifier, acquiring a target operating voltage of the power amplifier according to the peak power and the saturation power of the power amplifier, and increasing the operating voltage of the power amplifier according to the target operating voltage; and

when the peak power is less than a minimum power in the power range corresponding to a current operating voltage of the power amplifier, acquiring the target operating voltage of the power amplifier according to the peak power and the saturation power of the power amplifier, and decreasing the operating voltage of the power amplifier according to the target operating voltage.

In an exemplary embodiment, the step of acquiring a target operating voltage of the power amplifier according to the peak power and the saturation power of the power amplifier includes:
acquiring the target operating voltage according to the peak power and a corresponding relationship table of a preset saturation power and the operating voltage of the power amplifier.

In an exemplary embodiment, the corresponding relationship table includes a corresponding relationship table of a saturation power and an operating voltage of the power amplifier at multiple frequency points.

The step of acquiring the target operating voltage according to the peak power and a corresponding relationship table of a preset saturation power and the operating voltage of the power amplifier includes:

when an actual transmitting frequency point of a transmitting signal exists in the corresponding relationship table, acquiring the corresponding target operating voltage directly from the corresponding relationship table according to the peak power; when the actual transmitting frequency point of the transmitting signal does not exist in the corresponding relationship table, determining two frequency points in the corresponding relationship table, between which the actual transmitting frequency point falls;

performing linear interpolation processing on a corresponding saturation power at the two frequency points to acquire a corresponding relationship table of a saturation power and an operating voltage at the actual transmitting frequency point; and

acquiring the target operating voltage according to the peak power and the corresponding relationship table of the saturation power and the operating voltage at the actual transmitting frequency point.

In an exemplary embodiment, the step of acquiring an average power of a transmitting signal includes:

acquiring the average power of the transmitting signal configured by a background; or

acquiring the average power of the transmitting signal by performing power detection on the transmitting signal.

In an exemplary embodiment, the step of acquiring the average power of the transmitting signal by performing power detection on the transmitting signal includes:

acquiring the average power of the transmitting signal by performing the power detection on the transmitting signal according to a preset period; and

when the peak power is less than the minimum power in the power range corresponding to the current operating voltage of the power amplifier, before acquiring the target operating voltage according to the peak power and the saturation power of the power amplifier, the method further includes:
judging whether a current number of times that the peak power is less than the minimum power is greater than or equal to a preset threshold, and when the current number of times that the peak power is less than the minimum power is greater than or equal to a preset threshold, acquiring the target operating voltage according to the peak power and the saturation power of the power amplifier.

In an exemplary embodiment, before acquiring the target operating voltage and increasing or decreasing the operating voltage of the power amplifier according to the target operating voltage, the method further includes:
regulating the peak power of the transmitting signal to be equal to or less than the saturation power corresponding to the target operating voltage.

In an exemplary embodiment, the step of regulating the peak power of the transmitting signal includes:

calculating a second peak clipping threshold after the voltage of the power amplifier is regulated according to a first peak clipping threshold corresponding to a rated power, a saturation power corresponding to the rated power and the saturation power corresponding to the target operating voltage; and

regulating the peak power of the transmitting signal by regulating a peak clipping threshold of the transmitting signal to be the second peak clipping threshold.

In an exemplary embodiment, before increasing or decreasing the operating voltage of the power amplifier according to the target operating voltage, the method further includes:

acquiring a gain variation of the power amplifier; and

regulating gain compensation for the transmitting signal to be the gain variation during a process of radio frequency processing.

In an exemplary embodiment, the step of acquiring a gain variation of the power amplifier includes:

acquiring the gain variation of the power amplifier according to the target operating voltage and a corresponding relationship table of the preset operating voltage and the gain variation of the power amplifier.

In an exemplary embodiment, the corresponding relationship table of the preset operating voltage and the gain variation of the power amplifier includes a corresponding relationship table of an operating voltages and gain variation of a power amplifier at the multiple frequency points;

the step of acquiring a gain variation of the power amplifier according to the target operating voltage and a corresponding relationship table of the preset operating voltage and the gain variation of the power amplifier includes: when the actual transmitting frequency point of the transmitting signal does not exists in the corresponding relationship table, determining two frequency points in the corresponding relationship table, between which the actual transmitting frequency point falls;

performing the linear interpolation processing on the corresponding gain variation at the two frequency points to acquire a corresponding relationship table of an operating voltage and a gain variation of the power amplifier at the actual transmitting frequency point; and

acquiring the gain variation of the power amplifier according to the target operating voltage, the corresponding relationship table of the operating voltage and the gain variation of the power amplifier at the actual transmitting frequency point.

Also provided is an apparatus for regulating a voltage of a power amplifier, the apparatus being applied to multi-standard base stations and including: a first acquisition module, a second acquisition module and a voltage regulation module, herein
the first acquisition module is configured to acquire an average power and a peak-to-average power ratio of a transmitting signal;
the second acquisition module is configured to acquire a peak power of the transmitting signal according to the average power and the peak-to-average power ratio; and
the voltage regulation module is configured to regulate an operating voltage of the power amplifier according to the peak power and a saturation power of the power amplifier.
In an exemplary embodiment, the voltage regulation module is configured to:

when the peak power is greater than a maximum power in a power range corresponding to a current operating voltage of the power amplifier, acquire a target operating voltage of the power amplifier according to the peak power and the saturation power of the power amplifier, and increase the operating voltage of the power amplifier according to the target operating voltage; and
when the peak power is less than a minimum power in the power range corresponding to the current operating voltage of the power amplifier, acquire the target operating voltage of the power amplifier according to the peak power and the saturation power of the power amplifier, and decrease the operating voltage of the power amplifier according to the target operating voltage.

In an exemplary embodiment, the voltage regulation module acquires the target operating voltage of the power amplifier based on the peak power and the saturation power of the power amplifier means that the voltage regulation module acquires the target operating voltage according to the peak power and a corresponding relationship table of the preset saturation power and the operating voltage of the power amplifier.

In an exemplary embodiment, the apparatus further includes a power regulation module, herein the power regulation module is configured to regulate the peak power of the transmitting signal to be equal to or less than the saturation power corresponding to the target operating voltage before the voltage regulation module acquires the target operating voltage and increases or decreases the operating voltage of the power amplifier according to the target operating voltage.

In an exemplary embodiment, the apparatus further includes a gain regulation module, herein the gain regulation module is configured to, before the voltage regulation module increases or decreases the operating voltage of the power amplifier according to the target operating voltage, acquire a gain variation of the power amplifier, and regulate gain compensation for the transmitting signal to be the gain variation during radio frequency processing.

In an exemplary embodiment, the gain regulation module acquires the gain variation of the power amplifier means that the gain regulation module acquires the gain variation of the power amplifier according to the target operating voltage and a corresponding relationship table of the preset operating voltage and the gain variation of the power amplifier.

An embodiment of the present invention further provides a computer readable storage medium storing program instructions stored, when executed, can implement the method described above.

The embodiments of the present invention provide a method and apparatus for regulating a voltage of a power amplifier so as to effectively improve the efficiency of reducing power consumption of the power amplifier in a multi-standard base station. The method for regulating the voltage of the power amplifier provided by the embodiment of present invention is applied to multi-standard base stations and includes: acquiring an average power and a peak-to-average power ratio of a transmitting signal; acquiring a peak power of the transmitting signal based on the average power and the peak-to-average power ratio; and regulating an operating voltage of the power amplifier according to the peak power and a saturation power of the power amplifier. The method for regulating the voltage of the power amplifier provided by the embodiment of present invention may regulate the voltage of the power amplifier according to the peak power and the saturation voltage of the power amplifier such that the peak power of the transmitting signal is consistent with the saturation power point of the power amplifier, and a power amplifier module always operates in the vicinity of the saturation point regardless of changes in the peak power of the transmitting signal. Because the power amplifier module always operates near the saturation point, the case where a transmitter cannot operate properly after the voltage is regulated is avoided. Further, it can be seen from the steps of the above-described method that the method in accordance with the embodiment of the present invention is not limited by the type of standard of the base station and can be applied to the multi-standard base stations. The voltage regulation method in accordance with the embodiment of the present invention implements low voltage power supply under low transmitting power and high voltage power supply under high transmitting power, and reduces power consumption of the power amplifier, thereby improving the efficiency of reducing power consumption of the entire base station system.

**Brief Description of the Drawings**

FIG. 1 is a flow chart of a method for regulating a voltage of a power amplifier in accordance with an embodiment one of the present invention.

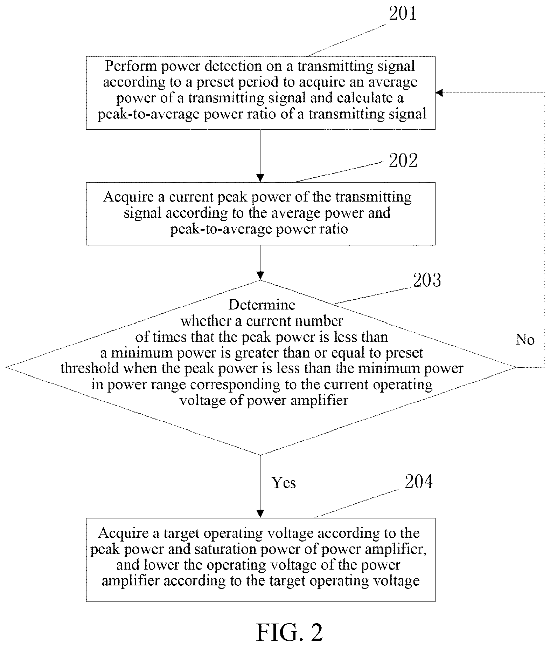

FIG. 2 is a flow chart of a method for regulating a voltage of a power amplifier in accordance with an embodiment two of the present invention.

FIG. 3 is a schematic diagram of a framework for regulating a voltage of a power amplifier in accordance with an embodiment four of the present invention.

FIG. 4 is a flow chart of a main control process for regulating the voltage of the power amplifier in accordance with the embodiment four of the present invention.

FIG. 5 is a flow chart of a method for setting the voltage in accordance with the embodiment four of the present invention.

FIG. 6 is a flow chart of a method for initializing voltage regulation of power amplifier in accordance with the embodiment four of the present invention.

FIG. 7 is a block diagram of a first apparatus for regulating a voltage of a power amplifier in accordance with an embodiment five of the present invention,

FIG. 8 is a block diagram of a second apparatus for regulating a voltage of a power amplifier in accordance with the embodiment five of the present invention.

FIG. 9 is a block diagram of a third apparatus for regulating a voltage of a power amplifier in accordance with the embodiment five of the present invention.

**Detailed Description**

Embodiment One

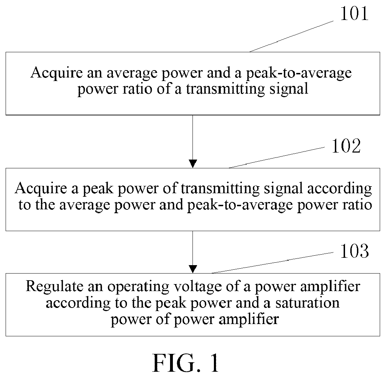

In view of the fact that, the voltage regulation technology in the related art cannot be applied to multi-standard base station products and transmitters cannot operate normally after the voltage of the power amplifier is regulated, an embodiment provides a new method for regulating a voltage, such that an operating voltage of the power amplifier can be adapted according to changes in the peak power and the power amplifier can be operated at a saturation power point, and the power consumption of the power amplifier is effectively reduced. As shown in Figure 1, the present embodiment provides a method for regulating a voltage of a power amplifier, which is applied to multi-standard base stations and includes step 101-step 103.

In step 101: an average power and a peak-to-average power ratio of a transmitting signal are acquired.

In that step, two processes in which the average power and the peak-to-average power ratio are acquired can be in any order, or simultaneously or successively.

Acquiring the average power of the transmit signal in that step may include the following two manners.

1. The average power of the transmitting signal configured by a background is acquired.

The power of the transmitting signal configured by the background of a network administrator is generally the average power of the transmitting signal, thus the average power can be acquired by only directly acquiring configuration data.

2. The power detection is performed on the transmitting signal to acquire the average power of the transmitting signal.

The manner is to perform the power detection on the transmitting signal in real time to acquire the average power, e.g., to monitor and detect changes in power of the transmitting signal.

For different standards of the base stations, values of the average power in the embodiment are also different.

When the standards of the base station include a GSM standard, the average power is a maximum time slot power of the GSM standard. GSM baseband data corresponds to a user according to a time slot, the voltage of the power amplifier is required to be regulated according to the maximum time slot power.

When the standards of the base station include an LTE standard, the average power is a maximum symbol power of an LTE standard product, an LTE baseband signal takes a symbol as a length of time, and the reference symbol power is high in general.

For UMTS and CDMA standard products, results of TSSI detection of the base station system's own transmitting power are required to be used, the transmitting power detected at this time is the average power.

The process of acquiring the peak-to-average power ratio of the transmitting signal in the present embodiment is as follows.

The peak-to-average power ratio of the transmitting signal is required to be calculated by software upon initialization, and the peak-to-average power ratio is a ratio of the peak power to the average power and is calculated by the following formula:

$$PAR = 20*\lg(cfr\_e\_gate/power\_e\_abs\_ave)$$

cft_e_gate is a corresponding peak clipping threshold at the rated power, and power_e_abs_ave is the mean square power of the output data after the peak power is clipped at the rated power.

In step 102: a peak power of the transmitting signal is acquired according to the average power and the peak-to-average power ratio.

In that step, the peak power of the transmitting signal is acquired by summing up the peak-to-average power ratio and the average power of the signal.

In step 103: an operating voltage of the power amplifier is regulated according to the peak power and a saturation power of the power amplifier.

The present step may include that, when the peak power is greater than a maximum power in a power range corresponding to the current operating voltage of the power amplifier, a target operating voltage of the power amplifier is acquired according to the peak power and the saturation power of the power amplifier, and the operating voltage of the power amplifier is increased according to the target operating voltage, that is, the voltage of the power amplifier is boosted.

When the peak power is less than a minimum power in the power range corresponding to the current operating voltage of the power amplifier, the target operating voltage of the power amplifier is acquired according to the peak power and the saturation power of the power amplifier, and the operating voltage of the power amplifier is decreased according to the target operating voltage, that is, the voltage of the power amplifier is lowered.

The method of the present embodiment can regulate the voltage of the power amplifier according to the peak power and the saturation power of the power amplifier, so that the peak power of the transmitting signal is consistent with the saturation power point of the power amplifier, and a power amplifier module always operates in proximity to the saturation point regardless of changes in the peak power of the transmitting signal. Because the power amplifier module always operates in proximity to the saturation point, the case where a transmitter cannot operate normally after the voltage is regulated is avoided. Further, it can be seen from the steps of the above-described method that the method in accordance with the embodiment of the present invention is not limited by the type of standard of the base station and can be applied to the multi-standard base stations. The method for regulating the voltage in accordance with the embodiment implements low voltage power supply under the low transmitting power and high voltage power supply under the high transmitting power, and reduces power consumption of the power amplifier, thereby improving the efficiency and reducing power consumption of the entire base station system.

In the present embodiment, the process of acquiring the target operating voltage of the power amplifier according to the peak power and the saturation power of the power amplifier may include that,

the target operating voltage is acquired according to the peak power and a corresponding relationship table of the preset saturation power and the operating voltage of the power amplifier.

In the method in accordance with the present embodiment, a corresponding relationship table (hereinafter referred to as a saturation power table) of the saturation power and the operating voltage of the power amplifier can be pre-stored, and after the peak power is acquired, the corresponding target voltage is acquired by matching the peak power in the saturation power table.

When there is a saturation power equal to the peak power in the saturation power table, the operating voltage corresponding to the saturation power is acquired directly. The operating voltage is the target operating voltage, that is, a voltage of the power amplifier that is required to be regulated finally.

When there is no saturation power equal to the peak power in the saturation power table, two saturation power values, between which the peak power falls are determined, operating voltages corresponding to the two saturation power values are acquired, and finally the maximum operating voltage is taken as the target operating voltage.

In that embodiment, an actual test is required to acquire the saturation power table. Each power amplifier in a production line may be tested and a table is created for an individual power amplifier, or each model of power amplifiers may be tested in the laboratory and a table is created for each model. The creation of the table for each model will reduce the complexity of the production process, but contents of the table will not completely correspond to each power amplifier. Due to certain batch discreteness in the production and raw materials of the power amplifier itself, rollback processing needs to be performed on the saturation power corresponding to the tested voltage in creating the table, the rollback is generally 0.3dB to 0.5dB, to ensure that each power amplifier can meet the power supply requirements. An interval of voltage tap positions of the power amplifier is determined by the regulation precision of a power supply module, which is generally 1V or 2V.

Generally, the saturation power table is a saturation power table at multiple frequency points, which records corresponding relationships between the saturation power and the operating voltage of the power amplifier at each frequency point. Because a transmitting center frequency point actually used in the base station on the network, generally do not exactly correspond to the existing frequency points in a voltage regulation table, the saturation power table also needs to be processed in actual use. The process of acquiring the target operating voltage according to the peak power, the corresponding relationship table of the preset saturation power and the operating voltage of the power amplifier includes following steps.

Two frequency points in the corresponding relationship table, between which the actual transmitting frequency point falls are determined, when the actual transmitting frequency point of the transmitting signal does not exist in the corresponding relationship table.

Linear interpolation processing is performed on the corresponding saturation power at the two frequency points to acquire a corresponding relationship table of the saturation power and the operating voltage at the actual transmitting frequency point.

The target operating voltage is acquired according to the peak power, and the corresponding relationship table of saturation power and the operating voltage at the actual transmitting frequency point.

When an actual transmitting frequency point of a transmitting signal exists in the corresponding relationship table, the corresponding target operating voltage is directly acquired according to the peak power and the corresponding relationship table without processing the saturation power table.

Embodiment two:

When users and services bore by a base station increase, the transmitting power will increase. In order to avoid affecting coverage and performance of the base station, the operating voltage of the power amplifier is required to be increased rapidly to improve a linear range of the power amplifier. Thus, the increase in the voltage needs to respond quickly, and the fast the better in engineering application. However, actual switching frequency is limited by technical limitations of the power supply module. At present, a boost response of hundreds of millisecond level can be implemented using the power supply module in the mobile base station in the industry, thereby a determination period of determining the general transmitting power is hundreds of milliseconds. Once it is found that a voltage tap position corresponding to the transmitting power is higher than the current voltage, a boost operation is required to be performed.

When the users and services bore by the base station are reduced, the transmitting power will be reduced. In order to improve the efficiency of the base station and reduce the static power consumption of the power amplifier module, the linear range of the power amplifier can be reduced and the operating voltage of the power amplifier module needs to be reduced. Because lowering the voltage does not affect the coverage of the base station in real time, in order to avoid ping pong repetition of regulation of the voltage at a certain tap position in the critical condition, the determination period of the operation for lowering the voltage needs to be longer, and the determination condition needs to be more stringent. The typical period of determination and regulation for lowering the voltage is several minutes. In the following, for the operation for lowering the voltage, the present embodiment provides a method for regulating a voltage of a power amplifier including step 201-step 204.

In step 201: power detection is performed on the transmitting signal according to a preset period to acquire an average power of the transmitting signal and a peak-to-average power ratio of the transmitting signal is calculated.

The preset period can be set to 200ms.

In step 202: a current peak power of the transmitting signal is acquired according to the average power and the peak-to-average power ratio.

In step 203: when the peak power is less than the minimum power in the power range corresponding to the current operating voltage of the power amplifier, whether a current number of times that the peak power is less than the minimum power is greater than or equal to the preset threshold is judged. If yes, step 204 is performed, and if no, the method returns to step 201.

In the method in accordance with the present embodiment, a counter can be used to record the current number of times that the peak power is less than the minimum power, that is, the number of times that of operations for lowering the voltage is required to be performed is determined. The counter is increased by 1 whenever it is determined that the operation for lowering the voltage is required to be performed. The counter is cleared if it is determined that the operation is not the operation of lowering the voltage. That is, the operation of lowering the voltage can be performed only if it is determined in succession that the number of times of the operations of lowering the voltage to be performed is greater than the preset threshold value, and if not, the power continues to be detected for determination.

For example, when it is determined in succession that the number of times that the operations of lowering the voltage to be performed is more than 600 times, the operation of lowering the voltage is performed.

In step 204: the target operating voltage is acquired according to the peak power and the saturation power of the power amplifier, and the operating voltage of the power amplifier is lowered according to the target operating voltage.

In method in accordance with the present embodiment, when the average power is a digital power detected in real time, the operation of lowering the voltage is performed only if it is determined n times in succession that the operation of lowering the voltage is required to be performed, and if no, the operation of lowering the voltage is not performed. The method in accordance with the present embodiment lengthens the determination time of the - operation of lowering the voltage and the determination condition becomes more stringent, avoids ping pong repetition of regulation of the voltage at a certain voltage tap position or a voltage value.

In the present embodiment, when the difference between the target operating voltage and the current operating voltage is relatively large, the voltage of the power amplifier can be regulated to the target operating voltage in a stepwise manner, that is, regulated completely with multiple steps, which avoids various problems, such as, larger changes in characteristics of the power amplifier caused that the voltage is regulated once for all, larger changes in the power of the transmitting signal with the gain of the power amplifier, possible interruption of access of services, greater impact on digital pre-distortion self-adaption of the power amplifier, longer regulation period adapted by a radio frequency index, and the like.

In the present embodiment, the operating voltage of the power amplifier can be divided into a plurality of tap positions. For example, it can be divided with the rated operating voltage being a reference point. Therefore, when the target operating voltage is acquired, the target voltage tap position is acquired too. If the magnitude of the voltage regulation is greater due to one-off regulation, then multi-step regulation can be used to regulate the voltage completely, for example, when the difference is 3 tap positions, the voltage can be regulated three times, one time a tap position.

Embodiment Three

In order to ensure normal transmission of services, the peak power input to the power amplifier is required not to exceed the saturation power corresponding to a target potential during the process of regulating the voltage of the power amplifier. Therefore, on the basis of the above-described embodiments one and two, the present embodiment provides a method for regulating the voltage of the power amplifier, which may further includes regulating the peak power of the transmitting signal to be equal to or less than the saturation power corresponding to the target operation voltage before the operating voltage of the power amplifier is regulated (increased or decreased). The method further includes regulating the peak power of the transmitting signal to be equal to or less than the saturation power corresponding to the target operation voltage after the target operating voltage is acquired and before the operating voltage of the power amplifier is increased or decreased according to the target operating voltage.

The peak power in a digital domain generally corresponds to a peak clipping threshold, thereby, in the present embodiment, the peak power of the transmitting signal may be regulated by regulating the peak clipping threshold. The step of regulating the peak power of the transmitting signal in the present embodiment includes the following steps.

A second peak clipping threshold after the voltage regulation of the power amplifier is calculated according to a first peak clipping threshold corresponding to a rated power, the saturation power corresponding to the rated power and the saturation power corresponding to the target operating voltage.

The peak power of the transmitting signal is regulated by regulating a peak clipping threshold of the transmitting signal to be the second peak clipping threshold.

The rated power in that embodiment is the rated power of the base station where the power amplifier is located.

The second peak clipping threshold after the voltage regulation of the power amplifier is calculated in proportion based on the input rated peak clipping threshold cfr_e_gate, the saturation power $p_e$ corresponding to the rated power and the saturation power $p_0$ corresponding to the target voltage:

$$cfr\_o\_gate = cfr\_e\_gate * \sqrt{\frac{P_o}{P_e}}$$

herein both $p_e$ and $p_0$ are saturation powers in the amplifier power voltage regulation table, the former is the saturation power corresponding to the rated power, and the latter is the saturation power corresponding to the target voltage. This is not the same as the digital power after peak is clipped acquired by the calculation of the peak-to-average.

For base station products of multi-transmitting channel and common power supply modules, the same operating voltage is required to be set for power amplifiers of multiple transmitting channels. At that point, the target voltage is looked up according to the maximum target output power, and the peak clipping threshold is calculated according to $p_e$ and $p_0$ of the maximum transmitting power channels. However, the channels need to be differentiated to acquire the rated power peak clipping threshold cfr_e_gate, thus the peak clipping threshold is required to be calculated and configured according to the different channels.

Considering the regulation of the operating voltage of the power amplifier will change the linearity and gain of the power amplifier, before the operating voltage is regulated in the voltage regulation process, changes in the gain of the power amplifier need to be compensated during radio frequency processing of a transmitter according to the changes in the gain of the power amplifier. For example, before the operating voltage is regulated in the voltage regulation process and after the peak power of the transmitting signal is regulated, the changes in the gain of the power amplifier need to be compensated during the radio frequency processing of the transmitter according to the changes in the gain of the power amplifier.

The method in accordance with the present embodiment, before the operating voltage of the power amplifier is increased or decreased according to the target operating voltage and after the peak power of the transmission signal is regulated; or before the operating voltage of the power amplifier is increased or decreased according to the target operating voltage, further includes the following steps.

A gain variation of the power amplifier is acquired. The gain compensation for the transmitting signal is regulated to be the gain variation during the radio frequency processing.

In the present embodiment, the gain variation of the power amplifier refers to the difference between a gain corresponding to the current operating voltage and a gain corresponding to the target operating voltage.

As the operating voltage of the power amplifier increases, the gain of the power amplifier will increase. In order to ensure that the transmitting power of the power amplifier is consistent with that of baseband. The signal is required to be attenuated in a radio frequency digital control attenuator of the transmitter, and the amount of attenuation is the increased amount of the gain of the power amplifier.

As the operating voltage of the power amplifier decreases, the gain of the power amplifier will decrease. In order to ensure between the transmitting power of the power amplifier is consistent with that of baseband. The signal is required to be amplified in the radio frequency digital control attenuator of the transmitter, and the amount of amplification is the decreased amount of the gain of the power amplifier.

The process of acquiring the gain variation of the power amplifier in the method in accordance with the present embodiment may include following steps.

The gain variation of the power amplifier is acquired according to the target operating voltage and a corresponding relationship table of the preset operating voltage and the gain variation of the power amplifier.

That is, in the method in accordance with the present embodiment, the gain variation of the power amplifier is required to be acquired according to the target operating voltage and the corresponding relationship table (hereinafter referred to as the power amplifier gain table) of the operating voltage and the gain variation of the power amplifier after the voltage of the power amplifier is regulated.

In the present embodiment, the power amplifier gain table is the corresponding relationship between voltage tap positions of the power amplifier and the gain variation of the power amplifier. The gain of the power amplifier changes with different supply voltages. After regulating the voltage of the power amplifier, the software needs to compensate the gain variation of the power amplifier on a transmitter link to ensure that the actual level of the transmitting power does not change with the regulated voltage of the power amplifier. An power amplifier gain sub-table is acquire through adaption detection of the software program, standard source signals are transmitted on entire machine products of the base station, digital and radio frequency gains of the transmitter are constant, the voltage tap positions of the power amplifier are traversed, and the output power of each of the voltage tap positions is detected to acquire the gain variation of the power amplifier.

Also considering actual transmitting frequency points, when actually used, in the base station on the network generally do not exactly correspond to the existing frequency points in the voltage regulation table, the power amplifier gain table also needs to be processed in actual use. The corresponding relationship table of the operating voltage and the gain variation of the power amplifier in the present embodiment includes a corresponding relationship table of the operating voltage and the gain variation of the power amplifier at multiple frequency points.

The step of acquiring the gain variation of the power amplifier according to at multiple frequency points of the target operating voltage, the preset operating voltage and the gain variation of the power amplifier includes following steps.

When the actual transmitting frequency point of the transmitting signal does not exists in the corresponding relationship table, two frequency points in the corresponding relationship table, between which the actual transmitting frequency point falls are determined.

The linear interpolation processing is performed on the corresponding gain variation at the two frequency points to acquire a corresponding relationship table of an operating voltage and a gain variation of the power amplifier at the actual transmitting frequency point.

The gain variation of the power amplifier is acquired according to the target operating voltage and corresponding relationship table of the operating voltage and the gain variation of the power amplifier at the actual transmitting frequency point.

In the method in accordance with the present embodiment, two frequency points corresponding relationship table, between which the actual transmitting frequency point falls, are determined first, and the compensated gain of the two frequency points is linearly interpolated to acquire the power amplifier gain table at the actual transmitting frequency point. If a transmitting center frequency point coincides exactly with a frequency point in the power amplifier gain table, then the gain variation of the corresponding frequency point is taken for gain compensation.

Alternatively, the amplifier gain table in the present embodiment and the saturation power table described in the above embodiment one can be represented in a same table, which is referred to as a power amplifier voltage regulation table, as shown in Table 1 below. A corresponding relationship between the saturation power and the voltage tap positions and a corresponding relationship between the compensated gain brought by the gain variation of the power amplifier and the voltage tap positions are required to be tested separately. In Table 1, the gain of the power amplifier at the rated voltage is a reference value, thus the compensated gain corresponding to the rated voltage is 0dB. Both the saturation power and the gain compensation of the power amplifier are more sensitive to the frequency, thus multiple frequency points in a transmission band are required to be tested. Fa is the lowest frequency point in the transmission band, and Fb is the highest frequency point in the transmission band. Starting from Fa, the voltage regulation table is tested with a certain step $\Delta 2$ to acquire the saturation power and gain variation corresponding to different voltage tap positions at different frequency points. Generally, the frequency step $\Delta 2$ is taken as 10MHz to 20MHz. The cutoff frequency point Fb is generally not on the step value, but this frequency point still needs to be tested.

Table 1

| Operating voltage | Fa | | Fa+$\Delta2$ | | Fa+$\Delta2*2$ | | .. | | Fb | |
|---|---|---|---|---|---|---|---|---|---|---|
| | Saturation power | Gain compensation | Saturation power | Gain compensation | Saturation power | Gain compensation | Saturation power | Gain compensation | Saturation power | Gain compensation |
| Ve | .. | 0 | .. | 0 | .. | 0 | .. | 0 | .. | 0 |
| Ve-$\Delta1$ | .. | .. | .. | .. | .. | .. | .. | .. | .. | .. |
| Ve-$\Delta1*2$ | .. | .. | .. | .. | .. | .. | .. | .. | .. | .. |
| Ve-$\Delta1*3$ | .. | .. | .. | .. | .. | .. | .. | .. | .. | .. |
| .. | .. | .. | .. | .. | .. | .. | .. | .. | .. | .. |

Note: Ve is the rated operating voltage of the power amplifier, $\Delta 1$ is the step of the voltage tap position step, Fa is the lowest frequency point in the transmitting band, Fb is the highest frequency point in the transmitting band, and $\Delta 2$ is a calibration step in the frequency domain corresponding to the compensated gain.

The power amplifier voltage regulation table characterizes hardware properties of the power amplifier, which need to be tested on the production line of the power amplifier module or the entire machine production line of the base station, and are written to a nonvolatile memory of the power amplifier or transmitter for use with the voltage regulation.

Embodiment four:

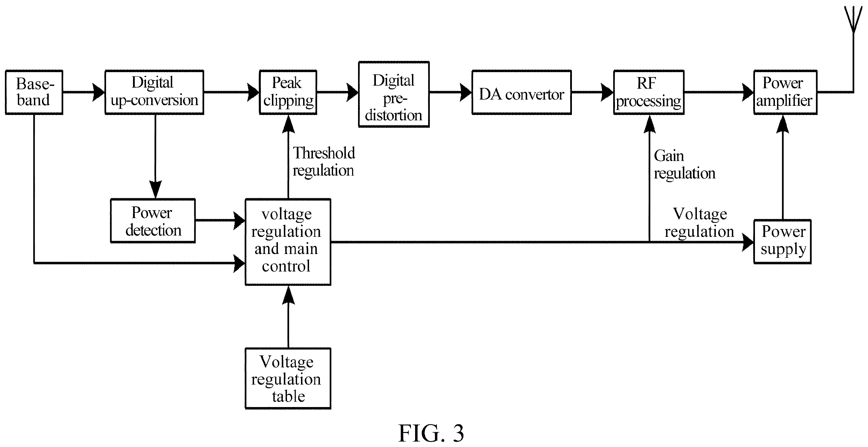

As shown in Fig. 3, there is provided a schematic diagram for implementing voltage regulation of a power amplifier using the method in accordance with the embodiment described above, herein a voltage regulation main controller judges voltage regulation according to a baseband configuration power or power detection of the transmitter, looks up the power amplifier voltage regulation table to acquire the target regulation voltage and the compensated gain, etc., and regulates and controls the clipping peak, the radio frequency gain of the transmitter link and the operating voltage of the power amplifier.

In the present embodiment, before the voltage regulation main controller regulates the voltage of the power amplifier, the peak clipping threshold of the transmitting signal is required to be regulated and the gain is compensated in the radio frequency processing.

In Fig. 3, the definition of the power amplifier voltage regulation table as shown in Table 1 characterizes the saturation power and the gain variation of the power amplifier corresponding to different voltage tap positions at different frequency points. A voltage tap position in the leftmost column is required to be prepared according to situations of product hardware of the base station. The rated operating voltage Ve of the power amplifier is an operating voltage corresponding to the rated transmitting power, determined by hardware of the power amplifier. The step $\Delta 1$ of the voltage tap positions is determined according to the regulation precision of the power supply, to be 1V or 2V, generally, and no more than 2V. When the change in the operating voltage of the power amplifier exceeds 2V, changes in the linearity and saturated power will be relatively large.

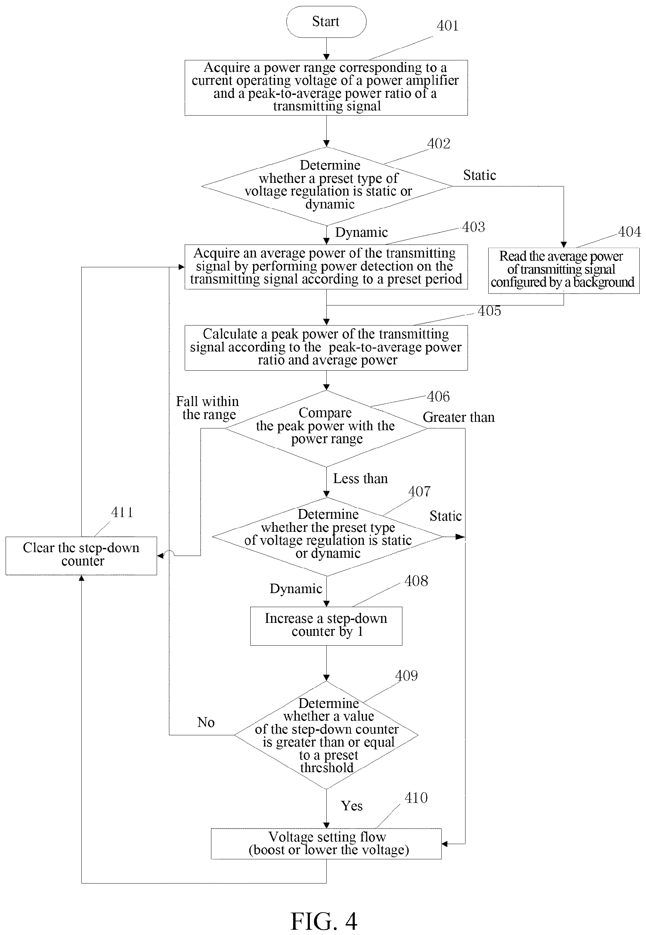

A flow chart of a main control process of voltage regulation is described, as shown in Fig. 4. After the voltage regulation is enabled, that process will be used to adaptively regulate the operating voltage of the power amplifier during running of the base station, which can reduce the energy consumption of mobile base stations and improving the operational efficiency of the entire network. The process includes step 401-step 411.

In step 401: a power range corresponding to the current operating voltage of the power amplifier and a peak-to-average power ratio of the transmitting signal are acquired.

In step 402: whether a preset type of voltage regulation is static or dynamic is judged. If the preset type of voltage regulation is dynamic, step 403 is performed, and if the preset type of voltage regulation is static, step 404 is performed.

The voltage of the power amplifier can be regulated according to a digital power of the transmitter detected in real time, at that point, a voltage regulation speed will be faster, and the voltage regulation is defined as dynamic voltage regulation in the present embodiment. The voltage may be regulated according to the value of the transmitting power directly configured to the transmitter by a background of a network administrator. Sending of the configured power barely occurs, which is defined as static voltage regulation in the present embodiment.

In step 403: the average power of the transmitting signal is acquired by performing power detection on the transmitting signal according to a preset period.

For example, the digital power of the transmitter is detected every 200 ms.

In step 404: the average power of the transmitting signal configured by the background is read.

In step 405: the peak power of the transmitting signal is calculated according to the peak-to-average power ratio and the average power, herein the peak power is acquired by addition.

In step 406: the peak power is compared with the power range. If the peak power is less than the power range, step 406 is performed, if the peak power is greater than the power range, step 410 is performed, and if the peak power falls within the power range, step 411 is performed.

If the peak power is less than a minimum value within the power range, the peak power is less than the power range, and if the peak power is greater than the maximum value within the power range, the peak power is greater than the power range.

In step 407: whether the preset type of voltage regulation is static or dynamic is determined again. If the preset type of voltage regulation is dynamic, step 407 is performed, and if the preset type of voltage regulation is static, step 409 is performed.

In step 408: a step-down counter is increased by 1.

In step 409: whether a value of the step-down counter is greater than or equal to a preset threshold is judged. If value of the step-down counter is greater than or equal to a preset threshold, step 409 is performed, and if value of the step-down counter is not greater than or equal to a preset threshold t, step 403 is performed.

In step 410: set a voltage flow (boost or lower).

In step 411: the step-down counter is cleared and the method returns to step 403.

According to Fig. 4, in a static voltage regulation mode, whether the power configured by the background is not within the power range corresponding to the current voltage is judged periodically, once it exceeds the range, the flow of boosting or lowering the voltage is started immediately.

In a dynamic regulation mode, once the digital power of the transmitter is detected to be higher than the power range corresponding to the current voltage tap position, the flow of boosting the voltage is required to be started immediately and the step-down counter is cleared. If the digital power of the transmitter is lower than the power range corresponding to the current voltage tap position, then the step-down counter is increase by 1, and whether the current step-down counter reaches a set value is judged. As soon as it reaches the set value, the flow of lowering the voltage is started, and the step-down counter is cleared after the voltage is decreased. In the example of Fig. 4, the set value of the step-down counter is 600 and corresponds to 2 minutes during 200 ms. Boosting the voltage is required to be as fast as possible in order to ensure that bearer services and coverage of the mobile base station will not affected, while response during lowering the voltage will be much slower and the determination condition is strict in order to ensure that the operation voltage of the power amplifier will not be regulated repeatedly at a critical power. The period of the power judgment is generally 100-600ms, that is, the fastest speed for the operation of boosting the voltage is 100-600ms, and the speed for the operation of lowering the voltage is on the order of minutes, 2 minutes in the example.

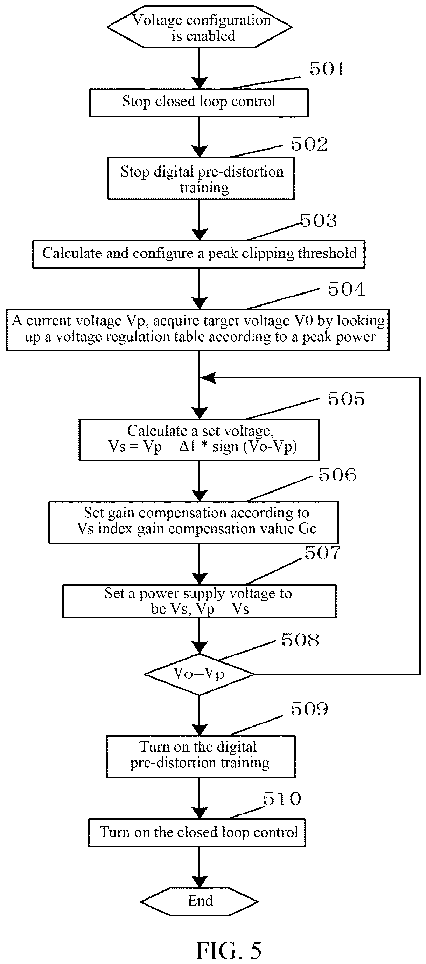

A process of setting the voltage in the present embodiment is described below. In a method in accordance with the embodiment, after process of setting the voltage begins to be performed, closed-loop power control and digital pre-distortion adaption training are stopped firstly, and then a peak clipping threshold is calculated and configured according to the maximum power corresponding to the target voltage tap position. As shown in Fig. 5, after the voltage configuration is enabled, the process includes steps 501- step 510.

In step 501: closed-loop power control is stopped.

In step 502: digital pre-distortion training is stopped.

In step 503: the peak clipping threshold is calculated and configured.

In step 504: the target voltage V0 is acquired by looking up the voltage regulation table according to the peak power.

In step 505: the set voltage is calculated by the formula Vs = Vp + $\Delta$1 * sign (Vo-Vp), herein Vp is a current voltage.

In step 506: the value Gc of gain compensation is acquired by looking up the voltage regulation table according to Vs, and Gc is set to be radio frequency gain compensation.

In step 507: the power supply voltage is set to be Vs, at that point, Vp = Vs.

In step 508: whether V0 is equal to Vp is judged. If not, the method returns step 503 re, if yes, then step 509 is performed.

In step 509: digital pre-distortion training is stared; and

In step 510: the closed loop control is started.

According to the description of Fig. 5, the voltage is required to be regulated gradually according to the step value of the voltage tap positions. If the one-off voltage regulation spans more than one voltage tap positions, then the voltage is required to be regulated completely one tap position after the other).

When the switching of the voltage tap positions is regulated, the peak clipping threshold is calculated firstly, then the change in the gain of the power amplifier is compensated in a digital control attenuator of a radio frequency link, and finally the power supply voltage is set.

After the power supply voltage is set to the target voltage tap position, the digital pre-distortion adaption training and closed-loop control are started.

So far, the self-adaption voltage regulation process of the power amplifier completes a closed loop, and it is to wait for the next power judgment process to perform the target voltage judgment and the adaption regulation processing.

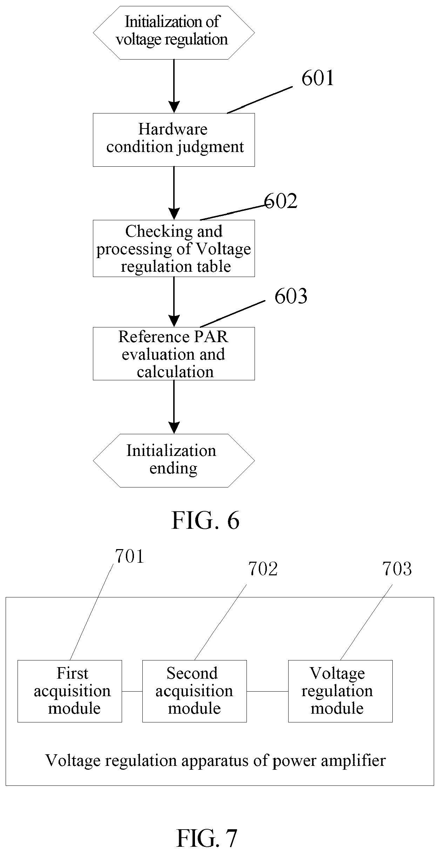

In the present embodiment, there may be an initialization process after the voltage regulation function of the power amplifier is activated. The initialization process can be carried out during the power-up initialization configuration of the base station. The initialization process is shown in Fig. 6 and includes steps 601-603. The initialization process is not directly performed on the transmitting signal, thus, no matter when the voltage regulation of the power amplifier is started, services running on the base station will not be interrupted. After the voltage regulation of the power amplifier is started, hardware is required to be judged firstly. Relevant hardware information, mainly information of the power module, is acquired to judge whether the voltage can be regulated and the range in which it can be regulated, and whether the power supply powers the power amplifier separately, and in the case that an electrically tunable antenna is powered at the same time, the voltage regulation range is required to be re-judged. If the power supply voltage can not be regulated, then the voltage regulation of the power amplifier is exited directly.

Checking and processing of the power voltage regulation table is subsequent to the initialization process. The existence of the voltage regulation table is checked, and the voltage regulation table is processed according to a transmitting center frequency point of the base station using a linear interpolation method, to acquire the saturation power and the value of compensated gain corresponding to the transmitting frequency point at different voltage tap positions.

Finally, reference PAR evaluation and calculation are performed.

Embodiment five

As shown in Fig. 7, the present embodiment provides an apparatus for regulating a voltage of a power amplifier. The apparatus is applied to multi-standard base stations and includes: a first acquisition module 701, a second acquisition module 702 and a voltage regulation module 703.

The first acquisition module 701 is configured to acquire an average power and a peak-to-average power ratio of a transmitting signal.

The second acquisition module 702 is configured to acquire a peak power of the transmitting signal according to the average power and the peak-to-average power ratio.

The voltage regulation module 703 is configured to regulate an operating voltage of the power amplifier according to the peak power and a saturation power of the power amplifier.

In an exemplary embodiment, the voltage regulation module 703 in the present embodiment is configured to, when the peak power is greater than the maximum power in a power range corresponding to the current operating voltage of the power amplifier, acquire a target operating voltage of the power amplifier according to the peak power and the saturation power of the power amplifier, and increase the operating voltage of the power amplifier according to the target operating voltage, and when the peak power is less than the minimum power in the power range corresponding to the current operating voltage of the power amplifier, acquire the target operating voltage of the power amplifier according to the peak power and the saturation power of the power amplifier, and decrease the operating voltage of the power amplifier according to the target operating voltage.

In an exemplary embodiment, the voltage regulation module 703 acquires the target operating voltage of the power amplifier according to the peak power and the saturation power of the power amplifier means that the voltage regulation module 703 acquires the target operating voltage according to the peak power and a corresponding relationship table of the preset saturation power and the operating voltage of the power amplifier.

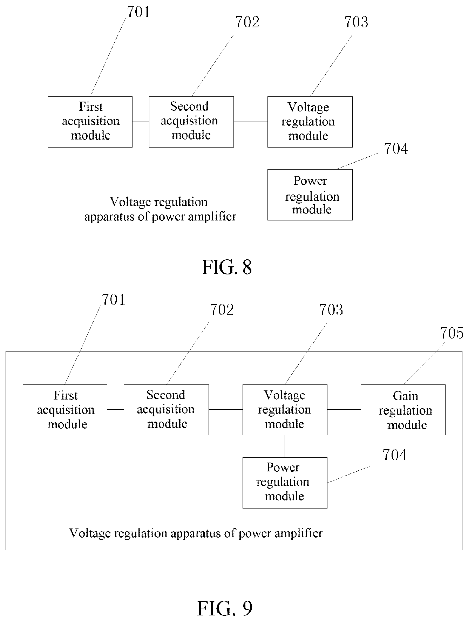

In an exemplary embodiment, as shown in FIG. 8, on the basis of the above-described apparatus, the apparatus further includes a power regulation module 704.

The power regulation module 704 is configured to regulate the peak power of the transmitting signal to be equal to or less than the saturation power corresponding to the target operating voltage before the target operating voltage is acquired and the operating voltage of the power amplifier is increased or decreased according to the target operating voltage.

In an exemplary embodiment, as shown in FIG. 9, on the basis of the above-described apparatus, the apparatus further includes a gain regulation module 705.

The gain regulation module 705 is configured to, before the operating voltage of the power amplifier is regulated, acquire a gain variation of the power amplifier, and regulate the gain compensation for the transmitting signal to be the gain variation during radio frequency processing.

In an exemplary embodiment, the gain regulation module 705 acquires the gain variation of the power amplifier means that the gain regulation module 705 acquires the gain variation of the power amplifier according to the target operating voltage, and the corresponding relationship table of the preset operating voltage and the gain variation of the power amplifier.

The ordinary person skilled in the art can understand that all or part of the steps in the above method can be completed by a program instructing related hardware, and the program can be stored in a computer readable memory medium, such as a read-only memory, disk or optical disk and so on. Alternatively, all or some of the steps of the abovementioned embodiments may also be implemented by using one or more integrated circuits. Accordingly, each module/unit in the abovementioned embodiments may be realized in a form of hardware, or in a form of software function modules. The present invention is not limited to any specific form of hardware and software combinations.

## Industrial Applicability

The method for regulating the voltage of the power amplifier provided by the embodiment of present invention may regulate the voltage of the power amplifier according to the peak power and the saturation voltage of the power amplifier, such that the peak power of the transmitting signal is consistent with the saturation power point of the power amplifier, and a power amplifier module always operates in proximity to the saturation point regardless of changes in the peak power of the transmitting signal. Because the power amplifier module always operates in proximity to the saturation point, the case where a transmitter cannot operate properly after the voltage is regulated is avoided. Further, the method in accordance with the embodiment of the present invention is not limited by the type of standard of the base station and can be applied to the multi-standard base stations. The voltage regulation method in accordance with the embodiment of the present invention implements low voltage power supply under low transmitting power and high voltage power supply under high transmitting power, and reduces power consumption of the power amplifier, thereby improving the efficiency of reducing power consumption of the entire base station system.

**Claims**

1. A method for regulating a voltage of a power amplifier, applied to multi-standard base stations and comprising following steps of:

   acquiring (101) an average power and a peak-to-average power ratio of a transmitting signal;
   acquiring (102) a peak power of the transmitting signal according to the average power and the peak-to-average power ratio; and
   regulating (103) an operating voltage of the power amplifier according to the peak power and a saturation power of the power amplifier, **characterized in that**,
   wherein the step of regulating an operating voltage of the power amplifier according to the peak power and a saturation power of the power amplifier comprises:

   when the peak power is greater than a maximum power in a power range corresponding to a current operating voltage of the power amplifier, acquiring a target operating voltage of the power amplifier according to the peak power and the saturation power of the power amplifier, and increasing the operating voltage of the power amplifier according to the target operating voltage; and
   when the peak power is less than a minimum power in the power range corresponding to the current operating voltage of the power amplifier, acquiring the target operating voltage of the power amplifier according to the peak power and the saturation power of the power amplifier, and decreasing the operating voltage of the power amplifier according to the target operating voltage.

2. The method according to claim 1, wherein the step of acquiring a target operating voltage of the power amplifier according to the peak power and the saturation power of the power amplifier comprises:
   acquiring the target operating voltage according to the peak power and a corresponding relationship table of a preset saturation power and the operating voltage of the power amplifier.

3. The method according to claim 2, wherein the corresponding relationship table comprises a corresponding relationship table of a saturation power and an operating voltage of the power amplifier at multiple frequency points;
   the step of acquiring the target operating voltage according to the peak power and a corresponding relationship table of a preset saturation power and the operating voltage of the power amplifier comprises:

   when an actual transmitting frequency point of a transmitting signal exists in the corresponding relationship table, acquiring a corresponding target operating voltage directly from the corresponding relationship table according to the peak power;
   when the actual transmitting frequency point of the transmitting signal does not exist in the corresponding relationship table, determining two frequency points in the corresponding relationship table, between which the actual transmitting frequency point falls,
   performing linear interpolation processing on corresponding saturation powers at the two frequency points to acquire a corresponding relationship table of a saturation power and an operating voltage at the actual transmitting frequency point; and
   acquiring the target operating voltage according to the peak power and the corresponding relationship table of the saturation power and the operating voltage at the actual transmitting frequency point.

4. The method according to claim 1 or 2 or 3, wherein the step of acquiring an average power of a transmitting signal comprises:

   acquiring the average power of the transmitting signal configured by a background; wherein, the power of the transmitting signal configured by the background of a network administrator is the average power of the transmitting signal, thus the average power can be acquired by only directly acquiring configuration data; or
   acquiring the average power of the transmitting signal by performing power detection on the transmitting signal, wherein the step of acquiring the average power of the transmitting signal by performing power detection on the transmitting signal comprises:

acquiring the average power of the transmitting signal by performing the power detection on the transmitting signal according to a preset period; and

when the peak power is less than the minimum power in the power range corresponding to the current operating voltage of the power amplifier, before acquiring the target operating voltage according to the peak power and the saturation power of the power amplifier,

the method further comprises: judging whether a current number of times that the peak power is less than the minimum power is greater than or equal to a preset threshold, and if when the current number of times that the peak power is less than the minimum power is greater than or equal to a preset threshold, acquiring the target operating voltage according to the peak power and the saturation power of the power amplifier.

5. The method according to claim 1, wherein before acquiring the target operating voltage and increasing or decreasing the operating voltage of the power amplifier according to the target operating voltage, the method further comprises: regulating the peak power of the transmitting signal to be equal to or less than the saturation power corresponding to the target operating voltage.

6. The method according to claim 5, wherein the step of regulating the peak power of the transmitting signal comprises:

calculating a second peak clipping threshold after the voltage of the power amplifier is regulated according to a first peak clipping threshold corresponding to a rated power, a saturation power corresponding to the rated power and the saturation power corresponding to the target operating voltage; and

regulating the peak power of the transmitting signal by regulating a peak clipping threshold of the transmitting signal to be the second peak clipping threshold.

7. The method according to claim 1 or 2 or 5, wherein before increasing or decreasing the operating voltage of the power amplifier according to the target operating voltage, the method further comprises: acquiring a gain variation of the power amplifier; and

regulating gain compensation for the transmitting signal to be the gain variation during radio frequency processing.

8. The method according to claim 7, wherein the step of acquiring a gain variation of the power amplifier comprises:

acquiring the gain variation of the power amplifier according to the target operating voltage and a corresponding relationship table of a preset operating voltage and the gain variation of the power amplifier,

wherein the corresponding relationship table of the preset operating voltage and the gain variation of the power amplifier comprises a corresponding relationship table of an operating voltage and an gain variation of the power amplifier at the multiple frequency points;

the step of acquiring a gain variation of the power amplifier according to the target operating voltage and a corresponding relationship table of the preset operating voltage and the gain variation of the power amplifier comprises:

when the actual transmitting frequency point of the transmitting signal does not exists in the corresponding relationship table, determining two frequency points in the corresponding relationship table, between which the actual transmitting frequency point falls;

performing the linear interpolation processing on the corresponding gain variation at the two frequency points to acquire a corresponding relationship table of an operating voltage and a gain variation of the power amplifier at the actual transmitting frequency point; and

acquiring the gain variation of the power amplifier according to the target operating voltage, the corresponding relationship table of the operating voltage and the gain variation of the power amplifier at the actual transmitting frequency point.

9. An apparatus for regulating a voltage of a power amplifier, applied to multi-standard base stations and comprising: a first acquisition module, a second acquisition module and a voltage regulation module, wherein

the first acquisition module is (701) configured to acquire an average power and a peak-to-average power ratio of a transmitting signal;

the second acquisition module (702) is configured to acquire a peak power of the transmitting signal according to the average power and the peak-to-average power ratio; and

the voltage regulation module (703) is configured to regulate an operating voltage of the power amplifier according to the peak power and a saturation power of the power amplifier, **characterized in that**,
wherein the voltage regulation module is configured to:

when the peak power is greater than a maximum power in a power range corresponding to a current operating voltage of the power amplifier, acquire a target operating voltage of the power amplifier according to the peak power and the saturation power of the power amplifier, and increase the operating voltage of the power amplifier according to the target operating voltage; and
when the peak power is less than a minimum power in the power range corresponding to the current operating voltage of the power amplifier, acquire the target operating voltage of the power amplifier according to the peak power and the saturation power of the power amplifier, and decrease the operating voltage of the power amplifier according to the target operating voltage.

10. The apparatus according to claim 9, wherein the voltage regulation module is configured to acquire a target operating voltage of the power amplifier according to the peak power and the saturation power of the power amplifier in a following way:
the voltage regulation module acquiring the target operating voltage according to the peak power and a corresponding relationship table of a preset saturation power and the operating voltage of the power amplifier.

11. The apparatus according to claim 9 or 10, further comprising a power regulation module, wherein
the power regulation module is configured to regulate the peak power of the transmitting signal to be equal to or less than a saturation power corresponding to the target operating voltage before the voltage regulation module acquires the target operating voltage and increases the operating voltage of the power amplifier according to the target operating voltage.

12. The apparatus according to claim 9 or 10, further comprising a gain regulation module, wherein
the gain regulation module is configured to, before the voltage regulation module increases or decreases the operating voltage of the power amplifier according to the target operating voltage, acquire a gain variation of the power amplifier, and regulate gain compensation for the transmitting signal to be the gain variation during radio frequency processing,
wherein the gain regulation module is configured to acquire a gain variation of the power amplifier in a following way:
the gain regulation module acquiring the gain variation of the power amplifier according to the target operating voltage and a corresponding relationship table of the preset operating voltage and the gain variation of the power amplifier.

13. A computer readable storage medium, storing program instructions, which, when executed, implement the method according to any one of claims 1-8.

**Patentansprüche**

1. Spannungsregelungsverfahren für einen Leistungsverstärker, das bei Multistandard-Basisstationen angewendet wird und folgende Schritte umfasst:

Erfassen (101) einer Durchschnittsleistung und eines Spitzen- zu Durchschnittsleistungs-Verhältnisses eines Übertragungssignals;
Erfassen (102) einer Spitzenleistung des Übertragungssignals in Abhängigkeit von der Durchschnittsleistung und vom Spitzen-zu-Durchschnittsleistungs-Verhältnis; und
Einstellen (103) einer Betriebsspannung des Leistungsverstärkers in Abhängigkeit von der Spitzenleistung und einer Sättigungsleistung des Leistungsverstärkers, **dadurch gekennzeichnet, dass**
wobei der Schritt des Einstellens einer Betriebsspannung des Leistungsverstärkers in Abhängigkeit von der Spitzenleistung und einer Sättigungsleistung des Leistungsverstärkers Folgendes umfasst:

wenn die Spitzenleistung höher als eine Höchstleistung in einem Leistungsbereich ist, der einer momentanen Betriebsspannung des Leistungsverstärkers entspricht, Erfassen einer Zielbetriebsspannung des Leistungsverstärkers in Abhängigkeit von der Spitzenleistung und der Sättigungsleistung des Leistungsverstärkers und Erhöhen der Betriebsspannung des Leistungsverstärkers in Abhängigkeit von der Zielbetriebsspannung; und
wenn die Spitzenleistung geringer als eine Mindestleistung in dem Leistungsbereich ist, der der momentanen Betriebsspannung des Leistungsverstärkers entspricht, Erfassen der Zielbetriebsspannung des Leistungsverstärkers in Abhängigkeit von der Spitzenleistung und der Sättigungsleistung des Leistungsverstärkers und Vermindern der Betriebsspannung des Leistungsverstärkers in Abhängigkeit von der Zielbetriebsspannung.

2. Verfahren nach Anspruch 1, wobei der Schritt des Erfassens einer Zielbetriebsspannung des Leistungsverstärkers in Abhängigkeit von der Spitzenleistung und der Sättigungsleistung des Leistungsverstärkers Folgendes umfasst: Erfassen der Zielbetriebsspannung in Abhängigkeit von der Spitzenleistung und einer entsprechenden Beziehungstabelle einer voreingestellten Sättigungsleistung und der Betriebsspannung des Leistungsverstärkers.

3. Verfahren nach Anspruch 2, wobei die entsprechende Beziehungstabelle eine entsprechende Beziehungstabelle einer Sättigungsleistung und einer Betriebsspannung des Leistungsverstärkers in Mehrfachfrequenzpunkten umfasst;

der Schritt des Erfassens der Zielbetriebsspannung in Abhängigkeit von der Spitzenleistung und einer entsprechenden Beziehungstabelle einer voreingestellten Sättigungsleistung und der Betriebsspannung des Leistungsverstärkers Folgendes umfasst:

wenn ein momentaner Übertragungsfrequenzpunkt eines Übertragungssignals in der entsprechenden Beziehungstabelle vorhanden ist, Erfassen einer entsprechenden Zielbetriebsspannung direkt aus der entsprechenden Beziehungstabelle in Abhängigkeit von der Spitzenleistung;

wenn der momentane Übertragungsfrequenzpunkt des Übertragungssignals nicht in der entsprechenden Beziehungstabelle vorhanden ist, Bestimmen zweier Frequenzpunkte in der entsprechenden Beziehungstabelle zwischen denen der momentane Übertragungsfrequenzpunkt liegt,

Durchführen einer linearen Interpolationsverarbeitung bei entsprechenden Sättigungsleistungen in den beiden Frequenzpunkten, um eine entsprechende Beziehungstabelle einer Sättigungsleistung und einer Betriebsspannung in dem momentanen Übertragungsfrequenzpunkt zu erfassen; und

Erfassen der Zielbetriebsspannung in Abhängigkeit von der Spitzenleistung und der entsprechenden Beziehungstabelle der Sättigungsleistung und der Betriebsspannung in dem momentanen Übertragungsfrequenzpunkt.

4. Verfahren nach Anspruch 1 oder 2 oder 3, wobei der Schritt des Erfassens einer Durchschnittsleistung eines Übertragungssignals Folgendes umfasst:

Erfassen der Durchschnittsleistung des Übertragungssignals, das aus einem Hintergrund konfiguriert ist; wobei die Leistung des aus dem Hintergrund eines Netzwerkadministrators konfigurierten Übertragungssignals die Durchschnittsleistung des Übertragungssignals ist, wodurch die Durchschnittsleistung nur durch direktes Erfassen der Konfigurationsdaten erfasst werden kann; oder

Erfassen der Durchschnittsleistung des Übertragungssignals durch Ausführen der Leistungsdetektion beim Übertragungssignal,

wobei der Schritt des Erfassens der Durchschnittsleistung des Übertragungssignals durch Ausführen von Leistungsdetektion beim Übertragungssignal Folgendes umfasst:

Erfassen der Durchschnittsleistung des Übertragungssignals durch Ausführen der Leistungsdetektion beim Übertragungssignal in Abhängigkeit von einem voreingestellten Zeitraum; und

wenn die Spitzenleistung geringer als die Mindestleistung in dem Leistungsbereich ist, der der momentanen Betriebsspannung des Leistungsverstärkers entspricht, vor dem Erfassen der Zielbetriebsspannung in Abhängigkeit von der Spitzenleistung und der Sättigungsleistung des Leistungsverstärkers,

umfasst das Verfahren ferner Folgendes: Beurteilen ob, eine momentane Anzahl von Malen, in denen die Spitzenleistung geringer als die Mindestleistung ist, größer oder gleich einem voreingestellten Schwellenwert ist, und wenn die momentane Anzahl von Malen, in denen die Spitzenleistung geringer als die Mindestleistung ist, größer oder gleich einem voreingestellten Schwellenwert ist, Erfassen der Zielbetriebsspannung in Abhängigkeit von der Spitzenleistung und der Sättigungsleistung des Leistungsverstärkers.

5. Verfahren nach Anspruch 1, wobei das Verfahren vor dem Erfassen der Zielbetriebsspannung und Erhöhen oder Vermindern der Betriebsspannung des Leistungsverstärkers in Abhängigkeit von der Zielbetriebsspannung ferner Folgendes umfasst:
Einstellen der Spitzenleistung des Übertragungssignals, damit diese gleich oder geringer als die Sättigungsleistung ist, die der Zielbetriebsspannung entspricht.

**6.** Verfahren nach Anspruch 5, wobei der Schritt des Einstellens der Spitzenleistung des Übertragungssignals Folgendes umfasst:

Berechnen einer zweiten Spitzenbegrenzungsschwelle nach dem Einstellen der Spannung des Leistungsverstärkers in Abhängigkeit von einer ersten Spitzenbegrenzungsschwelle, die einer Nennleistung entspricht, einer Sättigungsleistung, die der Nennleistung entspricht, und der Sättigungsleistung, die der Zielbetriebsspannung entspricht; und

Einstellen der Spitzenleistung des Übertragungssignals durch Einstellen einer Spitzenbegrenzungsschwelle des Übertragungssignals als zweite Spitzenbegrenzungsschwelle.

**7.** Verfahren nach Anspruch 1 oder 2 oder 5, wobei das Verfahren vor dem Erhöhen oder Vermindern der Betriebsspannung des Leistungsverstärkers in Abhängigkeit von der Zielbetriebsspannung ferner Folgendes umfasst: Erfassen einer Verstärkungsabweichung des Leistungsverstärkers; und

Einstellen der Verstärkungskompensation für das Übertragungssignal als Verstärkungsabweichung während der Funkfrequenzverarbeitung.

**8.** Verfahren nach Anspruch 7, wobei der Schritt des Erfassens einer Verstärkungsabweichung des Leistungsverstärkers Folgendes umfasst:

Erfassen der Verstärkungsabweichung des Leistungsverstärkers in Abhängigkeit von der Zielbetriebsspannung und einer entsprechenden Beziehungstabelle einer voreingestellten Betriebsspannung und der Verstärkungsabweichung des Leistungsverstärkers,

wobei die entsprechende Beziehungstabelle der voreingestellten Betriebsspannung und die Verstärkungsabweichung des Leistungsverstärkers eine entsprechende Beziehungstabelle einer Betriebsspannung und eine Verstärkungsabweichung des Leistungsverstärkers in den Mehrfachfrequenzpunkten umfasst;

der Schritt des Erfassens einer Verstärkungsabweichung des Leistungsverstärkers in Abhängigkeit von der Zielbetriebsspannung und einer entsprechenden Beziehungstabelle der voreingestellten Betriebsspannung und der Verstärkungsabweichung des Leistungsverstärkers Folgendes umfasst:

wenn der momentane Übertragungsfrequenzpunkt des Übertragungssignals nicht in der entsprechenden Beziehungstabelle vorhanden ist, Bestimmen zweier Frequenzpunkte in der entsprechenden Beziehungstabelle, zwischen denen der momentane Übertragungsfrequenzpunkt liegt;

Durchführen einer linearen Interpolationsverarbeitung bei der entsprechenden Verstärkungsabweichung in den beiden Frequenzpunkten, um eine entsprechende Beziehungstabelle einer Betriebsspannung und eine Verstärkungsabweichung des Leistungsverstärkers in dem momentanen Übertragungsfrequenzpunkt zu erfassen; und

Erfassen der Verstärkungsabweichung des Leistungsverstärkers in Abhängigkeit von der Zielbetriebsspannung, der entsprechenden Beziehungstabelle der Betriebsspannung und der Verstärkungsabweichung des Leistungsverstärkers in dem momentanen Übertragungsfrequenzpunkt.

**9.** Vorrichtung zum Einstellen einer Spannung eines Leistungsverstärkers, die bei Multistandard-Basisstationen angewendet wird und Folgendes umfasst: ein erstes Erfassungsmodul, ein zweites Erfassungsmodul und ein Spannungseinstellmodul, wobei

das erste Erfassungsmodul (701) konfiguriert ist, um eine Durchschnittsleistung und ein Spitzen-zu-Durchschnittsleistung-Verhältnis des Übertragungssignals zu erfassen;

das zweite Erfassungsmodul (702) konfiguriert ist, um eine Spitzenleistung des Übertragungssignals in Abhängigkeit von der Durchschnittsleistung und dem Spitzen-zu-Durchschnittsleistung-Verhältnis zu erfassen; und

das Spannungseinstellmodul (703) konfiguriert ist, um eine Betriebsspannung des Leistungsverstärkers in Abhängigkeit von der Spitzenleistung und einer Sättigungsleistung des Leistungsverstärkers einzustellen, **dadurch gekennzeichnet, dass**

wobei das Spannungseinstellmodul konfiguriert ist, um dann:

wenn die Spitzenleistung höher als eine Höchstleistung in einem Leistungsbereich ist, der einer momentanen Betriebsspannung des Leistungsverstärkers entspricht, eine Zielbetriebsspannung des Leistungsverstärkers in Abhängigkeit von der Spitzenleistung und der Sättigungsleistung des Leistungsverstärkers zu erfassen und die Betriebsspannung des Leistungsverstärkers in Abhängigkeit von der Zielbetriebsspannung zu erhöhen; und

wenn die Spitzenleistung geringer als eine Mindestleistung in dem Leistungsbereich ist, der der momentanen Betriebsspannung des Leistungsverstärkers entspricht, die Zielbetriebsspannung des Leistungsverstärkers in Abhängigkeit von der Spitzenleistung und der Sättigungsleistung des Leistungsverstärkers zu erfassen und die Betriebsspannung des Leistungsverstärkers in Abhängigkeit von der Zielbetriebsspannung zu vermindern.

10. Vorrichtung nach Anspruch 9, wobei das Spannungseinstellmodul konfiguriert ist, um eine Zielbetriebsspannung des Leistungsverstärkers in Abhängigkeit von der Spitzenleistung und der Sättigungsleistung des Leistungsverstärkers auf folgende Weise zu erfassen:
Erfassen - seitens des Spannungseinstellmoduls - der Zielbetriebsspannung in Abhängigkeit von der Spitzenleistung und einer entsprechenden Beziehungstabelle einer voreingestellten Sättigungsleistung und der Betriebsspannung des Leistungsverstärkers.

11. Vorrichtung nach Anspruch 9 oder 10, ferner umfassend ein Leistungseinstellmodul, wobei
das Leistungseinstellmodul konfiguriert ist, um die Spitzenleistung des Übertragungssignals so einzustellen, dass es gleich oder geringer als eine Sättigungsleistung ist, die der Zielbetriebsspannung entspricht, bevor das Spannungseinstellmodul die Zielbetriebsspannung erfasst, und die Betriebsspannung des Leistungsverstärkers in Abhängigkeit von Zielbetriebsspannung erhöht.

12. Vorrichtung nach Anspruch 9 oder 10, ferner umfassend ein Verstärkungseinstellmodul, wobei
das Verstärkungseinstellmodul konfiguriert ist, um vor dem Erhöhen oder Vermindern der Betriebsspannung des Leistungsverstärkers seitens des Spannungseinstellmoduls in Abhängigkeit von Zielbetriebsspannung, eine Verstärkungsabweichung des Leistungsverstärkers zu erfassen und die Verstärkungskompensation für das Übertragungssignal als Verstärkungsabweichung während der Funkfrequenzverarbeitung einzustellen,
wobei das Verstärkungseinstellmodul konfiguriert ist, um eine Verstärkungsabweichung des Leistungsverstärkers auf folgende Weise zu erfassen:
Erfassen der Verstärkungsabweichung des Leistungsverstärkers - seitens des Verstärkungseinstellmoduls - in Abhängigkeit von der Zielbetriebsspannung und einer entsprechenden Beziehungstabelle der voreingestellten Betriebsspannung und der Verstärkungsabweichung des Leistungsverstärkers.

13. Computerlesbares Speichermedium, in dem Programmanweisungen gespeichert sind, bei deren Ausführung das Verfahren gemäß einem der Ansprüche 1-8 implementiert wird.


**Revendications**

1. Procédé de régulation de tension d'un amplificateur de puissance, appliqué à des stations de base multistandard et comprenant les étapes suivantes :

l'acquisition (101) d'une puissance moyenne et d'un rapport entre puissance de crête et puissance moyenne d'un signal de transmission ;
l'acquisition (102) d'une puissance de crête du signal de transmission en fonction de la puissance moyenne et du rapport entre puissance de crête et puissance moyenne ; et
la régulation (103) une tension de fonctionnement de l'amplificateur de puissance en fonction de la puissance de crête et une puissance de saturation de l'amplificateur de puissance, **caractérisé en ce que**,
dans lequel l'étape de régulation d'une tension de fonctionnement de l'amplificateur de puissance en fonction de la puissance de crête et une puissance de saturation de l'amplificateur de puissance comprend :

quand la puissance de crête est supérieure à une puissance maximale dans une plage de puissances correspondant à une tension de fonctionnement actuelle de l'amplificateur de puissance, l'acquisition d'une tension de fonctionnement cible de l'amplificateur de puissance en fonction de la puissance de crête et de la puissance de saturation de l'amplificateur de puissance, et l'augmentation de la tension de fonctionnement de l'amplificateur de puissance en fonction de la tension de fonctionnement cible ; et
quand la puissance de crête est inférieure à une puissance minimale dans la plage de puissances correspondant à la tension de fonctionnement actuelle de l'amplificateur de puissance, l'acquisition de la tension de fonctionnement cible de l'amplificateur de puissance en fonction de la puissance de crête et de la puissance de saturation de l'amplificateur de puissance, et la diminution de la tension de fonctionnement de l'amplificateur de puissance en fonction de la tension de fonctionnement cible.

**2.** Procédé selon la revendication 1, dans lequel l'étape de l'acquisition une tension de fonctionnement cible de l'amplificateur de puissance en fonction de la puissance de crête et la puissance de saturation de l'amplificateur de puissance comprend :
l'acquisition de la tension de fonctionnement cible en fonction de la puissance de crête et une table de relation de correspondance of une puissance de saturation prédéfinie et la tension de fonctionnement de l'amplificateur de puissance.

**3.** Procédé selon la revendication 2, dans lequel la table de relation de correspondance comprend une table de relation de correspondance d'une puissance de saturation et d'une tension de fonctionnement de l'amplificateur de puissance au niveau de multiples points de fréquence ;
l'étape d'acquisition de la tension de fonctionnement cible en fonction de la puissance de crête et une table de relation de correspondance d'une puissance de saturation prédéfinie et de la tension de fonctionnement de l'amplificateur de puissance comprend :

   quand un point de fréquence de transmission actuel d'un signal de transmission existe dans la table de relation de correspondance, l'acquisition d'une tension de fonctionnement cible correspondante directement à partir de la table de relation de correspondance en fonction de la puissance de crête ;
   quand le point de fréquence de transmission actuel du signal de transmission n'existe pas dans la table de relation de correspondance, la détermination de deux points de fréquence dans la table de relation de correspondance, entre lesquels se trouve le point de fréquence de transmission actuel,
   l'exécution d'un traitement d'interpolation linéaire sur des puissances de saturation correspondantes au niveau des deux points de fréquence pour acquérir une table de relation de correspondance d'une puissance de saturation et d'une tension de fonctionnement au point de fréquence de transmission actuel ; et
   l'acquisition de la tension de fonctionnement cible en fonction de la puissance de crête et la table de relation de correspondance de la puissance de saturation et de la tension de fonctionnement au point de fréquence de transmission actuel.

**4.** Procédé selon la revendication 1 ou 2 ou 3, dans lequel l'étape d'acquisition d'une puissance moyenne d'un signal de transmission comprend :

   l'acquisition de la puissance moyenne du signal de transmission configuré par un arrière-plan ; dans lequel, la puissance du signal de transmission configuré par l'arrière-plan d'un administrateur de réseau est la puissance moyenne du signal de transmission, ainsi la puissance moyenne peut être acquise en acquérant seulement directement des données de configuration ; ou
   l'acquisition de la puissance moyenne du signal de transmission en effectuant une détection de puissance sur le signal de transmission,
   dans lequel l'étape d'acquisition de la puissance moyenne du signal de transmission en effectuant une détection de puissance sur le signal de transmission comprend :

      l'acquisition de la puissance moyenne du signal de transmission en effectuant la détection de puissance sur le signal de transmission en fonction d'une période prédéfinie ; et
      quand la puissance de crête est inférieure à la puissance minimale dans la plage de puissances correspondant à la tension de fonctionnement actuelle de l'amplificateur de puissance, avant l'acquisition de la tension de fonctionnement cible en fonction de la puissance de crête et la puissance de saturation de l'amplificateur de puissance,

   le procédé comprend en outre : le fait de juger si un nombre actuel de fois que la puissance de crête est inférieure à la puissance minimale est supérieure à ou égale à un seuil prédéfini, et si, quand le nombre actuel de fois que la puissance de crête est inférieure à la puissance minimale est supérieure à ou égale à un seuil prédéfini, l'acquisition de la tension de fonctionnement cible en fonction de la puissance de crête et la puissance de saturation de l'amplificateur de puissance.

**5.** Procédé selon la revendication 1, dans lequel, avant l'acquisition de la tension de fonctionnement cible et l'augmentation ou la diminution de la tension de fonctionnement de l'amplificateur de puissance en fonction de la tension de fonctionnement cible, le procédé comprend en outre :
la régulation de la puissance de crête du signal de transmission pour qu'elle soit égale ou inférieure à la puissance de saturation correspondant à la tension de fonctionnement cible.

**6.** Procédé selon la revendication 5, dans lequel l'étape de la régulation de la puissance de crête du signal de transmission comprend :

le calcul d'un deuxième seuil d'écrêtage après que la tension de l'amplificateur de puissance est régulée en fonction d'un premier seuil d'écrêtage correspondant à une puissance nominale, une puissance de saturation correspondant à la puissance nominale et la puissance de saturation correspondant à la tension de fonctionnement cible ; et
la régulation de la puissance de crête du signal de transmission en régulant un seuil d'écrêtage du signal de transmission pour qu'il soit le deuxième seuil d'écrêtage.

**7.** Procédé selon la revendication 1 ou 2 ou 5, dans lequel, avant l'augmentation ou la diminution de la tension de fonctionnement de l'amplificateur de puissance en fonction de la tension de fonctionnement cible, le procédé comprend en outre : l'acquisition d'une variation de gain de l'amplificateur de puissance, et
la régulation de compensation de gain pour le signal de transmission pour qu'elle soit la variation de gain durant le traitement de radiofréquence.

**8.** Procédé selon la revendication 7, dans lequel l'étape d'acquisition d'une variation de gain de l'amplificateur de puissance comprend :

l'acquisition de la variation de gain de l'amplificateur de puissance en fonction de la tension de fonctionnement cible et d'une table de relation de correspondance d'une tension de fonctionnement prédéfinie et de la variation de gain de l'amplificateur de puissance,
dans lequel la table de relation de correspondance de la tension de fonctionnement prédéfinie et de la variation de gain de l'amplificateur de puissance comprend une table de relation de correspondance d'une tension de fonctionnement et d'une variation de gain de l'amplificateur de puissance au niveau des multiples points de fréquence ;
l'étape d'acquisition d'une variation de gain de l'amplificateur de puissance en fonction de la tension de fonctionnement cible et d'une table de relation de correspondance de la tension de fonctionnement prédéfinie et de la variation de gain de l'amplificateur de puissance comprend :

quand le point de fréquence de transmission actuel du signal de transmission n'existe pas dans la table de relation de correspondance, la détermination de deux points de fréquence dans la table de relation de correspondance, entre lesquels se trouve le point de fréquence de transmission actuel ;
l'exécution du traitement d'interpolation linéaire sur la variation de gain correspondante au niveau des deux points de fréquence pour acquérir une table de relation de correspondance d'une tension de fonctionnement et d'une variation de gain de l'amplificateur de puissance au point de fréquence de transmission actuel ; et
l'acquisition de la variation de gain de l'amplificateur de puissance en fonction de la tension de fonctionnement cible, la table de relation de correspondance de la tension de fonctionnement et la variation de gain de l'amplificateur de puissance au point de fréquence de transmission actuel.

**9.** Appareil de régulation d'une tension d'un amplificateur de puissance, appliqué à des stations de base multistandard et comprenant : un premier module d'acquisition, un deuxième module d'acquisition et un module de régulation de tension, dans lequel
le premier module d'acquisition (701) est configuré pour acquérir une puissance moyenne et un rapport entre puissance de crête et puissance moyenne d'un signal de transmission ;
le deuxième module d'acquisition (702) est configuré pour acquérir une puissance de crête du signal de transmission en fonction de la puissance moyenne et du rapport entre puissance de crête et puissance moyenne ; et
le module de régulation de tension (703) est configuré pour réguler une tension de fonctionnement de l'amplificateur de puissance en fonction de la puissance de crête et une puissance de saturation de l'amplificateur de puissance,
**caractérisé en ce que**,
dans lequel le module de régulation de tension est configuré pour :

quand la puissance de crête est supérieure à une puissance maximale dans une plage de puissances correspondant à une tension de fonctionnement actuelle de l'amplificateur de puissance, acquérir une tension de fonctionnement cible de l'amplificateur de puissance en fonction de la puissance de crête et la puissance de saturation de l'amplificateur de puissance, et augmenter la tension de fonctionnement de l'amplificateur de puissance en fonction de la tension de fonctionnement cible ; et
quand la puissance de crête est inférieure à une puissance minimale dans la plage de puissances correspondant à la tension de fonctionnement actuelle de l'amplificateur de puissance, acquérir la tension de fonctionnement cible de l'amplificateur de puissance en fonction de la puissance de crête et la puissance de saturation de l'amplificateur de puissance, et diminuer la tension de fonctionnement de l'amplificateur de puissance en fonction de la tension de fonctionnement cible.

10. Appareil selon la revendication 9, dans lequel le module de régulation de tension est configuré pour acquérir une tension de fonctionnement cible de l'amplificateur de puissance en fonction de la puissance de crête et la puissance de saturation de l'amplificateur de puissance d'une manière suivante :
l'acquisition par le module de régulation de tension de la tension de fonctionnement cible en fonction de la puissance de crête et une table de relation de correspondance d'une puissance de saturation prédéfinie et la tension de fonctionnement de l'amplificateur de puissance.

11. Appareil selon la revendication 9 ou 10, comprenant en outre un module de régulation de puissance, dans lequel le module de régulation de puissance est configuré pour réguler la puissance de crête du signal de transmission pour qu'elle soit égale ou inférieure à une puissance de saturation correspondant à la tension de fonctionnement cible avant que le module de régulation de tension acquière la tension de fonctionnement cible et augmente la tension de fonctionnement de l'amplificateur de puissance en fonction de la tension de fonctionnement cible.

12. Appareil selon la revendication 9 ou 10, comprenant en outre un module de régulation de gain, dans lequel le module de régulation de gain est configuré pour, avant que le module de régulation de tension augmente ou diminue la tension de fonctionnement de l'amplificateur de puissance en fonction de la tension de fonctionnement cible, acquérir une variation de gain de l'amplificateur de puissance, et réguler une compensation de gain pour le signal de transmission pour qu'elle soit la variation de gain durant un traitement de radiofréquences,
dans lequel le module de régulation de gain est configuré pour acquérir une variation de gain de l'amplificateur de puissance d'une manière suivante :
le module de régulation de gain acquérant la variation de gain de l'amplificateur de puissance en fonction de la tension de fonctionnement cible et une table de relation de correspondance de la tension de fonctionnement prédéfinie et la variation de gain de l'amplificateur de puissance.

13. Support de stockage lisible par ordinateur, stockant des instructions de programme qui, quand elles sont exécutées, mettent en oeuvre le procédé selon l'une quelconque des revendications 1 à 8.

101

Acquire an average power and a peak-to-average
power ratio of a transmitting signal

102

Acquire a peak power of transmitting signal according
to the average power and peak-to-average power ratio

103

Regulate an operating voltage of a power amplifier
according to the peak power and a saturation
power of power amplifier

FIG. 1

201

Perform power detection on a transmitting signal according to a preset period to acquire an average power of a transmitting signal and calculate a peak-to-average power ratio of a transmitting signal

202

Acquire a current peak power of the transmitting signal according to the average power and peak-to-average power ratio

203

Determine whether a current number of times that the peak power is less than a minimum power is greater than or equal to preset threshold when the peak power is less than the minimum power in power range corresponding to the current operating voltage of power amplifier

No

Yes 204

Acquire a target operating voltage according to the peak power and saturation power of power amplifier, and lower the operating voltage of the power amplifier according to the target operating voltage

FIG. 2

FIG. 3

EP 3 209 071 B1

FIG. 4

```
        ╱▔▔▔▔▔▔▔▔▔▔╲
       ╱  Voltage configuration ╲
       ╲   is enabled          ╱
        ╲▁▁▁▁▁▁▁▁▁▁╱
              │
              ▼                    501
    ┌─────────────────────────┐
    │   Stop closed loop control │
    └─────────────────────────┘
              │
              ▼                    502
    ┌─────────────────────────┐
    │   Stop digital pre-distortion │
    │          training        │
    └─────────────────────────┘
              │
              ▼                    503
    ┌───────────────────────────────────┐
    │ Calculate and configure a peak clipping threshold │
    └───────────────────────────────────┘
              │
              ▼                    504
    ┌───────────────────────────────────────────────┐
    │ A current voltage Vp, acquire target voltage V0 by looking │
    │ up a voltage regulation table according to a peak power │
    └───────────────────────────────────────────────┘
              │
              ▼                    505
    ┌─────────────────────────────┐
    │     Calculate a set voltage,   │
    │  Vs = Vp + Δ1 * sign (Vo-Vp)  │
    └─────────────────────────────┘
              │
              ▼                    506
    ┌─────────────────────────────┐
    │ Set gain compensation according to │
    │ Vs index gain compensation value Gc │
    └─────────────────────────────┘
              │
              ▼                    507
    ┌─────────────────────────┐
    │  Set a power supply voltage to │
    │       be Vs, Vp = Vs      │
    └─────────────────────────┘
              │
              ▼                    508
          ╱▔▔▔▔╲
         ╱ Vo=Vp  ╲
         ╲       ╱
          ╲▁▁▁▁╱
              │
              ▼                    509
    ┌─────────────────────────┐
    │      Turn on the digital   │
    │    pre-distortion training  │
    └─────────────────────────┘
              │
              ▼                    510
    ┌─────────────────────────┐
    │  Turn on the closed loop control │
    └─────────────────────────┘
              │
              ▼
        ╱▔▔▔▔▔╲
       ╱   End    ╲
       ╲         ╱
        ╲▁▁▁▁▁╱
```

FIG. 5

Initialization of
voltage regulation

601

Hardware
condition judgment

602

Checking and
processing of Voltage
regulation table

603

Reference PAR
evaluation and
calculation

Initialization
ending

FIG. 6

701 702 703

| First acquisition module | Second acquisition module | Voltage regulation module |

Voltage regulation apparatus of power amplifier

FIG. 7

701    702    703

First
acquisition
module

Second
acquisition
module

Voltage
regulation
module

704

Power
regulation
module

Voltage regulation
apparatus of power amplifier

FIG. 8

701    702    703    705

First
acquisition
module

Second
acquisition
module

Voltage
regulation
module

Gain
regulation
module

Power
regulation
module

704

Voltage regulation apparatus of power amplifier

FIG. 9

**EP 3 209 071 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2226932 A1